# EUROPÄISCHE PATENTSCHRIFT

(11) **EP 3 113 363 B1**
(45) Veröffentlichungstag und Bekanntmachung des Hinweises auf die Patenterteilung: **10.03.2021**
(21) Anmeldenummer: 15174349.9
(22) Anmeldetag: 29.06.2015
(51) Int. Cl.: H03K 17/96, B60R 21/015

(54) **SENSORANORDNUNG**
SENSOR ASSEMBLY
SYSTÈME DE DÉTECTION

(43) Veröffentlichungstag der Anmeldung: 04.01.2017
(73) Patentinhaber: Aptiv Technologies Limited, St. Michael (BB)
(72) Erfinder: Reischl, Erik, 55765 Birkenfeld (DE); Schönfeld, Waldemar, 55543 Bad Kreuznach (DE); Wentzel, Christian, 55546 Biebelsheim (DE)
(74) Vertreter: Manitz Finsterwald Patent- und Rechtsanwaltspartnerschaft mbB

(56) Entgegenhaltungen:
- EP-A1- 2 275 243
- EP-A2- 1 471 360
- WO-A2-2005/041130
- DE-A1-102012 022 468
- JP-A- 2013 073 711
- US-A1- 2004 046 449

## Beschreibung

Die vorliegende Erfindung betrifft eine Sensoranordnung zur kapazitiven Detektion eines Objekts.

Solche Sensoranordnungen umfassen typischerweise eine Sensorelektrode und eine über der Sensorelektrode angeordnete Kappe. Die Kappe ist dafür vorgesehen, die Sensorelektrode vor äußeren Einflüssen zu schützen und so die Funktionsfähigkeit der Sensorelektrode zu gewährleisten. Eine derartige Sensoranordnung ist somit insbesondere als Näherungssensor geeignet, wobei ein sich der Kappe näherndes Objekt kapazitiv detektiert und ein unerwünschter Kontakt des Objekts mit der Sensorelektrode vermieden wird. Das Objekt kann insbesondere ein menschlicher Finger sein, welcher in die Nähe der Sensoranordnung geführt wird, um z.B. ein mit der Sensoranordnung kommunikativ verbundenes elektronisches Türschloss zu entriegeln. Das zugrundeliegende Detektionsprinzip beruht hierbei auf einer durch das Objekt verursachten Kapazitätsänderung zwischen der Sensorelektrode und einem Bezugspotential, wobei die Kapazitätsänderung selbst auf eine Änderung der Permittivität in der Umgebung der Sensorelektrode zurückzuführen ist.

Die Sensorelektrode der Sensoranordnung ist mittels einer zugeordneten Steuereinheit betreibbar, um aufgrund eines von der Sensorelektrode ausgehenden Sensorfeldes eine durch das Objekt hervorgerufene Kapazitätsänderung zu messen. Unter Berücksichtigung eines vorbestimmten Schwellenwerts kann auf bekannte Weise eine Detektion des Objekts durchgeführt werden, welches in einen zugeordneten Detektionsbereich der Sensoranordnung gebracht wird. Die Größe des Detektionsbereichs ist - zumindest in gewissen Grenzen, welche u.a. durch die Stärke des Sensorfeldes definiert sind - durch den Schwellenwert einstellbar.

Eine Funktion der Kappe besteht insbesondere darin, die Sensorelektrode vor einem unerwünschten Kontakt mit elektrisch leitfähigen Gegenständen, z.B. Bauteilen der Sensoranordnung, zu schützen. Hierdurch soll eine Übertragung von Ladungsträgern, z.B. im Zuge von elektrostatischen Entladungen, zwischen der Sensorelektrode und einem die Sensorelektrode kontaktierenden Gegenstand vermieden werden. D.h. das von der Sensorelektrode erzeugte Sensorfeld soll zum Zweck einer möglichst zuverlässigen Detektion von Objekten unbeeinträchtigt bleiben. Vor diesem Hintergrund besteht die Kappe in der Regel aus einem isolierenden Material, wie etwa Kunststoff. Bei Verwendung der Sensoranordnung zur Mensch-Maschine-Interaktion besitzen Kunststoffe jedoch den Nachteil, dass sie - insbesondere im Vergleich zu Metallen - von bestimmten Benutzerkreisen nicht als hochwertig wahrgenommen werden. Daher wird in zunehmendem Maße eine ästhetisch ansprechendere Gestaltung der Kappe angestrebt, wobei auf optisch wertig anmutende Metalle zurückgegriffen wird. Beispielsweise kann eine aus Kunststoff gebildete Kappe durch Galvanisierung mit einer chromhaltigen Metallisierung überzogen werden, wodurch die Sensoranordnung zumindest im Hinblick auf einen exponierten Kappenabschnitt besonders ansprechend wirkt.

Durch eine teilweise oder vollständige metallische Ausbildung der Kappe wird jedoch die oben beschriebene elektrische Schutzfunktion für die Sensorelektrode aufgegeben. Dies ist dadurch begründet, dass das Risiko von zumindest kurzzeitigen elektrischen Kontaktierungen der Sensorelektrode bei metallisch ausgebildeter Kappe prinzipiell erhöht ist. Um den Schutz der Sensorelektrode dennoch zu gewährleisten, ist es bekannt, die Sensorelektrode z.B. mit Epoxidharz zu vergießen. Dies stellt allerdings einen unerwünschten, mit Mehrkosten verbundenen Aufwand dar.

Daher ist es eine Aufgabe der Erfindung, eine Sensoranordnung der eingangs genannten Art anzugeben, bei der die Sensorelektrode auf kostengünstige Weise insbesondere von einer elektrisch leitfähigen Kappe der Sensoranordnung elektrisch geschützt ist.

WO 2005/041130 A2 offenbart eine Vorrichtung zur Detektion eines menschlichen Körpers, die in einem Türaußengriff angeordnet ist. Die Vorrichtung umfasst ein Kernelement, eine gefaltete Drahtelektrode sowie eine Blechplatte mit einem klammerförmigen Querschnitt. Die Drahtelektrode ist zwischen dem Kernelement und der Blechplatte angeordnet.

JP 2013-73711 A offenbart einen Drehschalter mit einer aus einem Draht zylindrisch geformten Elektrode, die sich zwischen einem Trägerelement und einer elektrisch leitenden Abdeckung erstreckt. Die Abdeckung überdeckt ein elektrisch isolierendes Betätigungselement des Drehschalters.

US 2004/0046449 A1 offenbart eine Vorrichtung zur Detektion der Anwesenheit eines Benutzers, wobei eine Elektrode zwischen einem ersten und einem zweiten isolierenden Teil angeordnet ist, wobei an der Oberfläche des zweiten isolierenden Teils eine elektrisch leitfähige Schicht vorgesehen ist.

EP 1 471 360 A2 offenbart eine gefaltete Drahtelektrode zur Anordnung in einem Türgriff.

Die Lösung der Aufgabe erfolgt durch eine Sensoranordnung mit den Merkmalen des Anspruchs 1.

Erfindungsgemäß umfasst die Sensoranordnung einen Träger, eine dem Träger zugeordnete, elektrisch leitfähige Kappe und einen elektrisch isolierten Leiter. Der elektrisch isolierte Leiter erstreckt sich zumindest teilweise schleifenförmig zwisehen der Kappe und dem Träger und ist mit einem Anschluss für eine Steuereinheit versehen. Die Kappe und der Träger bilden zusammen ein Gehäuse für den Leiter, welches gegenüber äußeren Einflüssen dichtend wirkt.

Durch das Gehäuse kann insbesondere das Eindringen von Feuchtigkeit in einen Raum zwischen der Kappe und dem Träger unterbunden werden. Dies ist z.B. vorteilhaft im Hinblick auf eine lange Lebensdauer der Sensoranordnung, da Alterungs- und Zersetzungsprozessen der Isolierung des Leiters und/oder einer folgenden Korrosion des Leiters entgegengewirkt wird. Zusätzlich kann das Gehäuse auch zur Aufnahme einer Steuereinheit der Sensoranordnung dienen.

Die erfindungsgemäße Sensoranordnung stellt für sich genommen ein Modul dar, welches durch eine zugeordnete Steuereinheit z.B. in der eingangs erläuterten Weise zur kapazitiven Detektion verwendet werden kann. Der elektrisch isolierte Leiter dient hierbei als Sensorelektrode, wobei die elektrische Isolierung den Leiter wirksam vor unerwünschten, insbesondere elektrostatischen Ladungsflüssen schützt.

Elektrisch isolierte Leiter sind als industriell hergestelltes Massenprodukt in nahezu allen denkbaren Varianten günstig verfügbar. Somit kann auf eine separate Isolierung der Sensorelektrode verzichtet werden zugunsten einer direkten Verwendung eines elektrisch isolierten und vorzugsweise flexiblen Leiters als Sensorelektrode. Somit ist insbesondere auch keine herkömmliche Sensorelektrode erforderlich, welche häufig als Metallplatte ausgebildet und dementsprechend aufwändig zu montieren bzw. zu befestigen ist. Insgesamt zeichnet sich die erfindungsgemäße Sensoranordnung durch ihren einfachen Aufbau aus, welcher insbesondere eine günstige industrielle Herstellung in hohen Stückzahlen erlaubt.

Die elektrisch leitfähige Kappe kann direkt von dem Träger getragen sein oder durch Zwischenbauteile insbesondere lösbar mit dem Träger verbunden sein. Die Kappe kann auch entgegen der Vorspannkraft einer Feder relativ zu dem Träger bewegbar sein, beispielsweise wenn die Kappe als Taster verwendet werden soll. Zwischen dem Träger und der Kappe kann ein Aufnahmeraum gebildet sein, in dem der Leiter angeordnet wird. Auch kann der Leiter teilweise oder vollständig in den Träger und/oder der Kappe eingebettet sein.

Die schleifenförmige Anordnung des Leiters ist besonders vorteilhaft hinsichtlich der Funktion des Leiters als Sensorelektrode. Durch die Schleifenform lässt sich z.B. ein im Vergleich zu dem Leiterquerschnitt großes Sensorfeld erzielen, das zumindest annähernd die Ausmaße der von dem Leiter aufgespannten Fläche aufweist. Ferner kann die Schleifenform des Leiters dahingehend genutzt werden, ein möglichst homogenes Sensorfeld zu erzeugen. Die Detektionsempfindlichkeit und Zuverlässigkeit der Sensoranordnung kann somit durch die schleifenförmige Anordnung des Leiters erhöht werden.

Unter einer Schleifenform ist jeder gekrümmte, im Wesentlichen konvexe Verlauf zu verstehen. Gemäß Anspruch 1 ist ein solcher Verlauf dann gegeben, wenn ein Ende des Leiters zu dem zweiten Ende des Leiters "zurückgeführt" und hierdurch eine Leiterschlaufe gebildet wird. Einzelne konkav oder gerade geformte Abschnitte stellen hierbei keine grundsätzliche Abweichung von der Schleifenform an sich dar. Unter eine Schleifenform fällt auch ein schlingenartiger Verlauf, der eine Fläche einschließt.

Weitere Ausführungsformen der erfindungsgemäßen Sensoranordnung sind in der Beschreibung, den Ansprüchen und den beigefügten Zeichnungen angegeben. Gemäß einer Ausführungsform liegt der Leiter zumindest abschnittsweise an der Unterseite der Kappe an. Als Unterseite ist in diesem Zusammenhang grundsätzlich eine Fläche der Kappe zu verstehen, welche dem Leiter und/oder dem Träger zugewandt ist. Durch Anliegen des Leiters an der Unterseite der Kappe kann der relative Durchgriff des von dem Leiter ausgehenden Sensorfeldes verbessert werden, d.h. das Sensorfeld erstreckt sich zu einem großen Teil jenseits der Kappe, wodurch der außenseitige Detektionsraum der Sensoranordnung vergrößert wird. Mit anderen Worten kann durch Anliegen des Leiters an der Unterseite der Kappe die Detektionsreichweite erhöht werden. Insbesondere kann der Leiter an denjenigen Abschnitten der Kappe anliegen, welche an einen gewünschten, außenseitigen Detektionsraum angrenzen.

Gemäß Anspruch 1 ist die Schleifenform des Leiters an die Form der Kappe angepasst. Beispielsweise kann sich der Leiter entlang einer Kontur und/oder eines Umfangs der Kappe erstrecken. Das Sensorfeld kann hierdurch entsprechend zu der Form der Kappe ausgebildet werden. Dies ist insbesondere dann vorteilhaft, wenn die Kappe einem Benutzer die Grenzen des Detektionsraums vermitteln soll. Somit kann die Annäherung eines Fingers des Benutzers an die Kappe, insbesondere auch aus seitlichen Richtungen, zuverlässig erkannt werden.

Gemäß einer weiteren Ausführungsform ist zwischen der Unterseite der Kappe und dem Träger ein Spalt gebildet, wobei die Weite des Spalts an eine Dicke des Leiters und/oder eine gewünschte Schleifenform angepasst ist. Hierdurch wird zumindest im Hinblick auf die Anordnung des Leiters eine kompakte Ausbildung der Sensoranordnung erzielt. Ferner wird bei an die Dicke des Leiters angepasster Spaltweite ein zwangsweises Anliegen des Leiters an der Unterseite der Kappe und somit ein bestmöglicher Durchgriff des Sensorfeldes durch die Kappe gewährleistet. Zusätzlich kann ein Verrutschen des Leiters zwischen der Kappe und dem Träger durch eine geeignete Dimensionierung des Spalts weitgehend ausgeschlossen werden. Beispielsweise kann die - nicht notwendigerweise konstante - Weite des Spalts so beschaffen sein, dass der Leiter zwischen der Kappe und dem Träger in dem Spalt fixiert wird.

Gemäß einer vorteilhaften Ausführungsform weist der Träger einen Führungsabschnitt auf, in den der Leiter abschnittsweise aufgenommen ist. Ein solcher Führungsabschnitt kann insbesondere als eine stutzenartige, lokale Leiterdurchführung des Trägers ausgebildet sein, wobei der Leiter mit seinen beiden Enden durch die Leiterdurchführung aus einem Zwischenraum zwischen der Kappe und dem Träger nach außen geführt wird, um dort an eine Steuereinheit angeschlossen zu werden. Die Leiterdurchführung kann insbesondere eine vollständige Schlingenform des Leiters gewährleisten, indem der Leiter in der Leiterdurchführung lokal zusammengeführt bzw. gebündelt wird. Ferner können auf den Leiter wirkende Zugkräfte aufgefangen bzw. kompensiert werden, so dass der Leiter beispielsweise nicht ungewollt aus dem Zwischenraum gezogen wird.

Mittels des Führungsabschnitts des Trägers kann der Leiter auch auf eine gewünschte Weise, z.B. in einem bestimmten Winkel relativ zu dem Träger und der Kappe, ausgerichtet wird, um etwa die Herstellung einer bestimmten Schleifenform des Leiters zu begünstigen. Darüber hinaus kann der Führungsabschnitt auch dichtend ausgebildet sein, z.B. in Form einer mit einer Dichtung ausgestatteten Öffnung in dem Träger. Alternativ sind auch zwei einfache, an den jeweiligen Leiterquerschnitt angepasste Öffnungen denkbar, welche lokal beabstandet voneinander an dem Träger ausgebildet sind.

Gemäß einer weiteren Ausführungsform ist der Leiter an seinen beiden Enden kurzgeschlossen, wobei der Leiter insbesondere an seinen Enden einen gemeinsamen, einpoligen Stecker zum Anschließen des Leiters an eine Steuereinheit aufweist. Hierdurch wird - im Vergleich zu dem Fall, dass jedes Ende einen Stecker aufweist - einerseits die Anzahl notwendiger Bauteile reduziert. Andererseits wird die Montage der Sensoranordnung vereinfacht, da nicht jedes Ende des Leiters separat angeschlossen werden muss.

Vorzugsweise weist die Kappe zumindest abschnittsweise ein Metall auf, welches insbesondere Chrom umfasst. Der Kappe kann hierdurch ein ansprechendes Äußeres verliehen werden. Vorzugsweise weist die Kappe einen Kunststoffkern auf, welcher mit einer chromhaltigen Metallisierung überzogen ist. Als Materialien für den Kunststoffkern kommen z.B. Acrylnitril-Butadien-Styrol (ABS) oder Polycarbonat (PC) in Frage.

Gemäß einer weiteren Ausführungsform ist die Kappe komplementär zu dem Träger ausgebildet. Hierbei kann zwischen der Kappe und dem Träger zumindest abschnittsweise ein Formschluss und/oder Kraftschluss gebildet sein. Die Sensoranordnung kann hierdurch einerseits kompakt ausgebildet werden, andererseits kann die Montage der Sensoranordnung hinsichtlich eines in sich abgeschlossenen Sensormoduls vereinfacht werden. Beispielsweise kann an der Kappe und/oder dem Träger eine Rastvorrichtung oder dergleichen vorgesehen sein, um den Träger und die Kappe mittels einer entsprechenden Rastverbindung miteinander zu verbinden. Vorzugsweise ist der Leiter zwischen der Kappe und dem Träger fixiert, wenn die Rastverbindung geschlossen ist.

Der Träger ist vorzugsweise aus einem Kunststoff, wie etwa Polyamid (PA) gebildet. Grundsätzlich sind aber auch andere Materialien, wie etwa Metalle, denkbar, wobei eine elektrische Leitfähigkeit des Trägers die Vorteile der vorliegenden Erfindung aufgrund der elektrischen Isolierung des Leiters nicht einschränkt.

Vorzugsweise ist der Leiter als eine handelsübliche, einadrige Leitung mit einer Kunststoffummantelung ausgebildet. Beispielsweise kann der Leiter eine Kupferleitung mit einer Querschnittsfläche von etwa 0,14 mm² sein, wobei die Kupferleitung von einem Polyvinylchloridmantel umgeben ist. Solche Leitungen sind in hohen Stückzahlen zu einem niedrigen Preis verfügbar und somit im Hinblick auf eine kostengünstige Herstellung der Sensoranordnung besonders vorteilhaft. Die Leitung weist insbesondere einen runden Querschnitt auf, welcher - z.B. im Vergleich zu kantigen Flachleitern - eine unproblematische Positionierung des Leiters zwischen der Kappe und dem Träger erlaubt. Darüber hinaus begünstigt der runde Querschnitt eine freie Verbiegbarkeit des Leiters, wodurch die Schleifenform des Leiters besonders einfach herstellbar ist. Der Leiterquerschnitt muss allerdings nicht notwendigerweise rund ausgebildet sein. So kann es in bestimmten Fällen sinnvoll sein, Leiter mit nicht rundem Querschnitt zu verwenden, beispielsweise wenn die Spaltweite zwischen der Kappe und dem Träger minimiert werden soll und/oder der Leiter mit seiner Isolierung möglichst flächig an der Unterseite der Kappe anliegen soll.

Gemäß einer Ausführungsform umfasst die Sensoranordnung eine Steuereinheit zum Betrieb des Leiters als Sensorelektrode. Die Steuereinheit ist hierbei insbesondere im Bereich des Trägers angeordnet ist. Beispielsweise kann die Steuereinheit an dem Träger befestigt sein. Die Steuereinheit kann eine Speichereinheit aufweisen, in welcher zum Betrieb der Sensorelektrode erforderliche Daten gespeichert sind.

Gemäß einer vorteilhaften Ausführungsform ist die oben beschriebene Sensoranordnung an einem Türaußengriff eines Fahrzeugs angeordnet. Hierzu kann der Träger an eine Fassung des Türaußengriffs angepasste Befestigungspunkte aufweisen, um die Sensoranordnung kraft- und/oder formschlüssig an dem Türaußengriff montieren zu können.

Nachfolgend wird die vorliegende Erfindung rein beispielhaft anhand von zwei vorteilhaften Ausführungsformen unter Bezugnahme auf die beigefügten Zeichnungen erläutert. Es zeigen:
- Fig. 1: eine schematische Querschnittsansicht einer Sensoranordnung zur kapazitiven Detektion eines Objekts,
- Fig. 2a: eine perspektivische Draufsicht einer Sensoranordnung mit montierter Kappe,
- Fig. 2b: die Sensoranordnung von Fig. 2a ohne montierte Kappe.

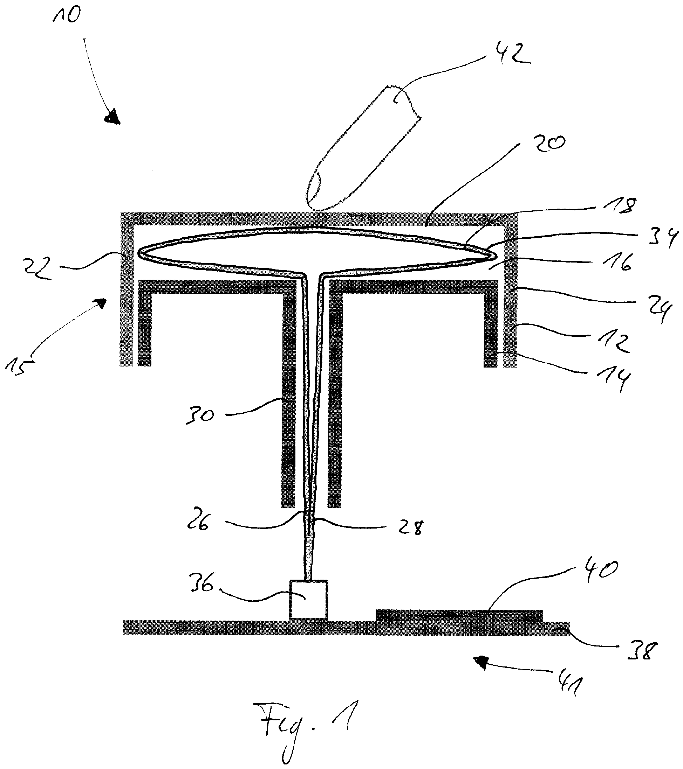

Fig. 1 zeigt eine erfindungsgemäße Sensoranordnung 10. Die Sensoranordnung 10 umfasst eine metallisierte Kappe 12 und einen aus Kunststoff gebildeten Träger 14. Der Träger 14 ist komplementär zu der Kappe 12 ausgebildet, wobei die Kappe 12 den Träger 14 teilweise umgreift. Der Träger 14 und die Kappe 12 bilden zusammen ein Gehäuse 15.

Zwischen der Kappe 12 und dem Träger 14 ist ein Spalt 16 gebildet, in dem sich ein elektrisch isolierter Leiter 18 schleifenförmig erstreckt. Wie in Fig. 1 angedeutet, stützt sich der Leiter 18 abschnittsweise an einer Decke 20 der Kappe 12, an Seitenwänden 22, 24 der Kappe 12 sowie an dem Träger 14 ab. Der Leiter 18 erstreckt sich somit vollständig zwischen der Kappe 12 und dem Träger 14, wodurch ein von dem Leiter 18 ausgehendes Sensorfeld (nicht gezeigt) bezüglich seiner Größe mit den Ausmaßen der Kappe 12 korrespondiert. Dies ist vorteilhaft, wenn die Kappe 12 von einem Benutzer als Sensorfläche wahrgenommen wird und eine Annäherung eines Objekts an die Kappe 12 durch das Sensorfeld des Leiters 18 detektierbar sein soll.

Die Weite des Spalts 16 ist an die Schleifenorm des Leiters 18 insofern angepasst, als dass sich die Schleifenform in dem Spalt 16 in der gezeigten Weise ausbilden kann. Elastische Eigenschaften des Leiters 18 tragen dazu bei, dass der Leiter 18 aufgrund einer mechanischen Eigenspannung die Schleifenform selbstständig beibehält und sich innerhalb des Gehäuses 15 abstützt.

Der Leiter 18 ist mit Enden 26, 28 durch einen Führungsabschnitt 30 des Trägers 14 geführt. Der Träger 14 und die Kappe 12 sind in dem vorliegenden Ausführungsbeispiel im Wesentlichen rotationssymmetrisch ausgebildet. Grundsätzlich sind aber auch nicht rotationssymmetrische Varianten denkbar.

Der Leiter 18 ist von einer Kunststoffummantelung 34 umgeben, wodurch der Leiter 18 insbesondere vor elektrostatischen Ladungen der Kappe 12 wirksam geschützt ist.

Die Enden 26, 28 des Leiters 18 sind mit einem einpoligen Stecker 36 verbunden, welcher an eine Leiterplatte 38 angeschlossen ist. Die Leiterplatte 38 weist einen Mikrocontroller 40 auf. Die Leiterplatte 38 und der Mikrocontroller 40 bilden zusammen eine Steuereinheit 41 für die Sensoranordnung 10, d.h. zum Betrieb des Leiters 18 als Sensorelektrode. Der Mikrocontroller 40 ist so konfiguriert, dass ein in der Nähe der Kappe 12 befindlicher Finger 42 detektiert wird. Zur Detektion des Fingers 42 ist es nicht notwendig, dass dieser die Kappe 12 berührt.

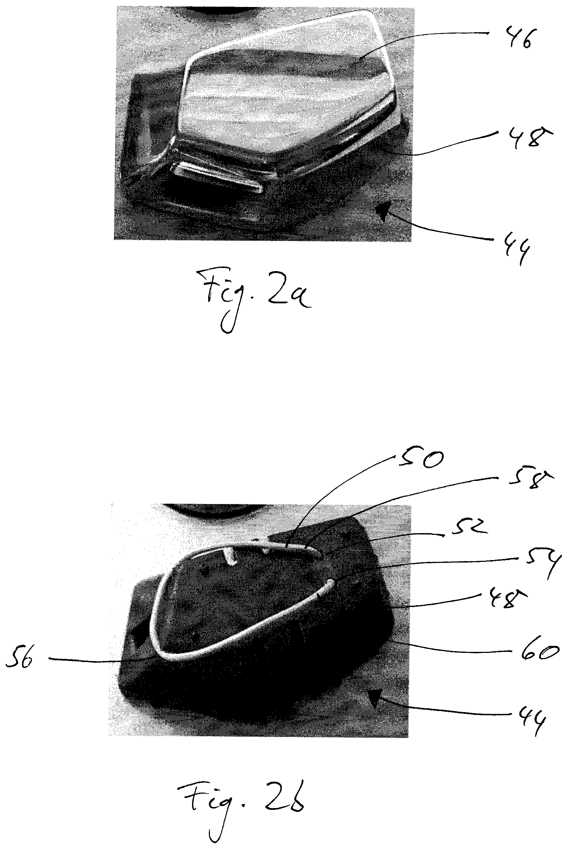

Fig. 2a zeigt eine perspektivische Draufsicht einer Sensoranordnung 44, welche eine verchromte Kappe 46 und einen aus Kunststoff gebildeten Träger 48 aufweist.

In Fig. 2b ist die Sensoranordnung 44 von Fig. 2a ohne die Kappe 46 dargestellt. Ein handelsüblicher, elektrisch isolierter Leiter 50 erstreckt sich schleifenförmig entlang des Trägers 48, wobei der Leiter 50 abschnittsweise in eine Ecknut 56 des Trägers 48 eingreift, um den Leiter 50 in der gezeigten Schleifenform zu halten.

Der Leiter 50 ist mit Enden 58, 60 durch zugeordnete Öffnungen 52, 54 des Trägers 48 geführt und mit einer nicht gezeigten Steuereinheit zur kapazitiven Detektion eines sich dem Leiter 50 bzw. der Kappe 46 (Fig. 2a) nähernden Objekts verbunden.

### Bezugszeichenliste

- 10: Sensoranordnung
- 12: Kappe
- 14: Träger
- 15: Gehäuse
- 16: Spalt
- 18: Leiter
- 20: Decke
- 22: Seitenwand
- 24: Seitenwand
- 26: Ende
- 28: Ende
- 30: Führungsabschnitt
- 34: Kunststoffummantelung
- 36: Stecker
- 38: Leiterplatte
- 40: Mikrocontroller
- 41: Steuereinheit
- 42: Finger
- 44: Sensoranordnung
- 46: Kappe
- 48: Träger
- 50: Leiter
- 52: Öffnung
- 54: Öffnung
- 56: Ecknut
- 58: Ende
- 60: Ende

## Patentansprüche

1. Sensoranordnung (10; 44) zur kapazitiven Detektion eines Objekts (42), umfassend:
einen Träger (14; 48),
eine dem Träger (14; 48) zugeordnete, elektrisch leitfähige Kappe (12; 46), und
einen elektrisch isolierten Leiter (18; 50), welcher sich zumindest teilweise schleifenförmig zwischen der Kappe (12; 46) und dem Träger (14; 48) erstreckt und mit einem Anschluss (36) für eine Steuereinheit (41) versehen ist, wobei ein erstes Ende des Leiters (18; 50) zu einem zweiten Ende des Leiters (18; 50) zurückgeführt ist, um eine einzelne Leiterschlaufe zu bilden, wobei die Schleifenform des Leiters (18; 50) an die Form der Kappe (12; 46) angepasst ist, und
wobei die Kappe (12; 46) und der Träger (14; 48) zusammen ein Gehäuse (15) für den Leiter (18; 50) bilden, welches gegenüber äußeren Einflüssen dichtend wirkt.

2. Sensoranordnung (10; 44) nach Anspruch 1,
**dadurch gekennzeichnet, dass**
der Leiter (18; 50) zumindest abschnittsweise an einer dem Leiter und/oder dem Träger zugewandten Seite (20, 22, 24) der Kappe (12; 46) anliegt.

3. Sensoranordnung (10; 44) nach zumindest einem der vorstehenden Ansprüche, **dadurch gekennzeichnet, dass**
zwischen einer dem Leiter und/oder dem Träger zugewandten Seite (20) der Kappe (12; 46) und dem Träger (14; 48) ein Spalt (16) gebildet ist, wobei die Weite des Spalts (16) an eine Dicke des Leiters (18; 50) und/oder eine gewünschte Schleifenform angepasst ist.

4. Sensoranordnung (10; 44) nach zumindest einem der vorstehenden Ansprüche, **dadurch gekennzeichnet, dass**
der Träger (14; 48) einen Führungsabschnitt (30) aufweist, in den der Leiter (18; 50) abschnittsweise aufgenommen ist.

5. Sensoranordnung (10; 44) nach zumindest einem der vorstehenden Ansprüche, **dadurch gekennzeichnet, dass**
der Leiter (18; 50) an seinen beiden Enden (26, 38; 58, 60) kurzgeschlossen ist, wobei der Leiter (18; 50) insbesondere an seinen Enden (26, 38; 58, 60) einen gemeinsamen, einpoligen Stecker (36) zum Anschließen des Leiters (18; 50) an eine Steuereinheit (41) aufweist.

6. Sensoranordnung (10; 44) nach zumindest einem der vorstehenden Ansprüche, **dadurch gekennzeichnet, dass**
die Kappe (12; 46) zumindest abschnittsweise ein Metall aufweist, welches insbesondere Chrom umfasst.

7. Sensoranordnung (10; 44) nach zumindest einem der vorstehenden Ansprüche, **dadurch gekennzeichnet, dass**
die Kappe (12; 46) komplementär zu dem Träger (14; 48) ausgebildet ist und zwischen der Kappe (12; 46) und dem Träger (14; 48) zumindest abschnittsweise ein Formschluss und/oder Kraftschluss gebildet ist.

8. Sensoranordnung (10; 44) nach zumindest einem der vorstehenden Ansprüche, **dadurch gekennzeichnet, dass**
der Leiter (18; 50) als eine einadrige Leitung mit einer Kunststoffummantelung (34) ausgebildet ist, wobei die Leitung insbesondere einen runden Querschnitt aufweist.

9. Sensoranordnung (10; 44) nach zumindest einem der vorstehenden Ansprüche, **dadurch gekennzeichnet, dass**
die Sensoranordnung (10; 44) eine Steuereinheit (41) umfasst, welche insbesondere im Bereich des Trägers (14; 48) angeordnet ist.

10. Türaußengriff eines Fahrzeugs mit einer Sensoranordnung (10; 44) nach zumindest einem der vorstehenden Ansprüche.

## Claims

1. A sensor arrangement (10; 44) for the capacitive detection of an object (42), comprising:
a support (14; 48);
an electrically conductive cap (12; 46) associated with the support (14; 48); and
an electrically insulated conductor (18; 50) which extends at least partly in loop shape between the cap (12; 46) and the support (14; 48) and which is provided with a connector (36) for a control unit (41), wherein a first end of the conductor (18; 50) is returned to a second end of the conductor (18; 50) to form a single conductor loop, wherein the loop shape of the conductor (18; 50) is adapted to the shape of the cap (12; 46), and
wherein the cap (12; 46) and the support (14; 48) together form a housing (15) for the conductor (18; 50), said housing (15) having a sealing effect against external influences.

2. A sensor arrangement (10; 44) in accordance with claim 1,
**characterized in that**
the conductor (18; 50) at least sectionally contacts a side (20, 22, 24) of the cap (12; 46) facing the conductor and/or the support.

3. A sensor arrangement (10; 44) in accordance with at least one of the preceding claims, **characterized in that**
a gap (16) is formed between a side (20) of the cap (12; 46) facing the conductor and/or the support and the support (14; 48), with the width of the gap (16) being adapted to a thickness of the conductor (18; 50) and/or to a desired loop shape.

4. A sensor arrangement (10; 44) in accordance with at least one of the preceding claims, **characterized in that**
the support (14; 48) has a guide section (30) in which the conductor (18; 50) is sectionally received.

5. A sensor arrangement (10; 44) in accordance with at least one of the preceding claims, **characterized in that**
the conductor (18; 50) is short circuited at its two ends (26, 38; 58, 60), with the conductor (18; 50), in particular at its ends (26, 38; 58, 60), having a common, single-pole plug (36) for connecting the conductor (18; 50) to a control unit (41).

6. A sensor arrangement (10; 44) in accordance with at least one of the preceding claims, **characterized in that**
the cap (12; 46) at least sectionally has a metal which in particular comprises chromium.

7. A vacuum apparatus (10) in accordance with at least one of the preceding claims, **characterized in that**
the cap (12; 46) is formed complementary to the support (14; 48) and a form fit and/or a force fit is/are formed at least sectionally between the cap (12; 46) and the support (14; 48).

8. A sensor arrangement (10; 44) in accordance with at least one of the preceding claims, **characterized in that**
the conductor (18; 50) is formed as a single-core line having a plastic jacket (34), with the line in particular having a round cross-section.

9. A sensor arrangement (10; 44) in accordance with at least one of the preceding claims, **characterized in that**
the sensor arrangement (10; 44) comprises a control unit (41) which is in particular arranged in the region of the carrier (14; 48).

10. An outside door handle of a vehicle comprising a sensor arrangement (10; 44) in accordance with at least one of the preceding claims.

## Revendications

1. Dispositif capteur (10 ; 44) pour la détection capacitive d'un objet (42), comprenant :
un support (14 ; 48),
un capuchon électriquement conducteur (12 ; 46) associé au support (14; 48), et
un conducteur électriquement isolé (18; 50) qui s'étend au moins partiellement en boucle entre le capuchon (12 ; 46) et le support (14 ; 48) et qui est pourvu d'une connexion (36) pour une unité de commande (41), dans lequel une première extrémité du conducteur (18 ; 50) est ramenée à une deuxième extrémité du conducteur (18 ; 50) pour former une boucle unique de conducteur, la forme de boucle du conducteur (18 ; 50) étant adaptée à la forme du capuchon (12 ; 46), et
dans lequel le capuchon (12; 46) et le support (14; 48) forment ensemble, pour le conducteur (18; 50), un boîtier (15) qui assure une étanchéité par rapport aux influences extérieures.

2. Dispositif capteur (10 ; 44) selon la revendication 1, **caractérisé en ce que**
le conducteur (18 ; 50) s'appuie au moins sur certaines parties contre un côté (20, 22, 24) du capuchon (12 ; 46) tourné vers le conducteur et/ou le support.

3. Dispositif capteur (10; 44) selon au moins l'une des revendications précédentes, **caractérisé en ce que**
un espace (16) est formé entre un côté (20) du capuchon (12 ; 46) tourné vers le conducteur et/ou le support et le support (14 ; 48), la largeur de l'espace (16) étant adaptée à une épaisseur du conducteur (18 ; 50) et/ou à une forme de boucle souhaitée.

4. Dispositif capteur (10; 44) selon au moins l'une des revendications précédentes, **caractérisé en ce que**
le support (14 ; 48) présente une partie de guidage (30) dans laquelle le conducteur (18 ; 50) est reçu sur certaines parties.

5. Dispositif capteur (10; 44) selon au moins l'une des revendications précédentes, **caractérisé en ce que**
le conducteur (18 ; 50) est court-circuité à ses deux extrémités (26, 38 ; 58, 60), le conducteur (18 ; 50) présentant, en particulier à ses extrémités (26, 38 ; 58, 60), une fiche unipolaire commune (36) pour la connexion du conducteur (18 ; 50) à une unité de commande (41).

6. Dispositif capteur (10; 44) selon au moins l'une des revendications précédentes, **caractérisé en ce que**
le capuchon (12 ; 46) présente, au moins sur certaines parties, un métal qui comprend en particulier du chrome.

7. Dispositif capteur (10; 44) selon au moins l'une des revendications précédentes, **caractérisé en ce que**
le capuchon (12 ; 46) est conçu complémentaire au support (14 ; 48) et un ajustement par complémentarité de forme et/ou par friction est formé entre le capuchon (12 ; 46) et le support (14 ; 48) au moins sur certaines parties.

8. Dispositif capteur (10; 44) selon au moins l'une des revendications précédentes, **caractérisé en ce que**
le conducteur (18 ; 50) est réalisé sous la forme d'une ligne unifilaire avec une gaine en matière plastique (34), la ligne ayant en particulier une section transversale ronde.

9. Dispositif capteur (10; 44) selon au moins l'une des revendications précédentes, **caractérisé en ce que**
le dispositif capteur (10 ; 44) comprend une unité de commande (41) qui est disposée en particulier dans la zone du support (14 ; 48).

10. Poignée extérieure de porte d'un véhicule dotée d'un dispositif capteur (10 ; 44) selon au moins l'une des revendications précédentes.
